# EUROPEAN PATENT APPLICATION

(11) **EP 1 870 714 A1**
(43) Date of publication of application: **26.12.2007**
(21) Application number: 06730693.6
(22) Date of filing: 30.03.2006
(51) Int. Cl.: G01R 1/073, G01P 21/00, G01C 9/06

(54) **MICROSTRUCTURE PROBE CARD, AND MICROSTRUCTURE INSPECTING DEVICE, METHOD, AND COMPUTER PROGRAM**

(30) Priority: 31.03.2005 JP 2005102751; 31.03.2005 JP 2005102760; 14.09.2005 JP 2005266720
(71) Applicant: Octec Inc., Shinjuku-ku, Tokyo 1600011 (JP); TOKYO ELECTRON LIMITED, Minato-ku Tokyo 107-8481 (JP)
(72) Inventor: OKUMURA, Katsuya Park House Yotsuya Wakaba 103, Tokyo 1600011 (JP); YAKABE, Masami c/o TOKYO ELECTRON AT LIMITED, Hyogo 6600891 (JP); IKEUCHI, Naoki c/o TOKYO ELECTRON AT LIMITED, Hyogo 6600891 (JP)
(74) Representative: Liesegang, Eva
(86) International application number: PCT/JP2006/306745
(87) International publication number: WO 2006/106876

(57) **Abstract**

An inspecting method which is for a microstructure with a movable portion and executes a highly precise inspection without damaging a probe or an inspection electrode by suppressing the effect of a needle pressure in contacting the probe to the inspection electrode is provided.

When inspection on a microstructure is performed, first, a pair of probes (2) are caused to contact respective electrode pads (PD), and the pair of probes (2) and a fritting power source (50) are connected together through relays (30). Next, a voltage is applied from the fritting power source (50) to one probe (2) in the pair of probes (2). As the voltage is gradually increased, an oxide film between the pair of probes (2) is destroyed and a current flows between the pair of probes (2) by fritting phenomenon, and the probes (2) and the electrode pad (PD) are electrically conducted each other. Subsequently, the pair of probes (2) are switched to a measuring unit (40) side from the fritting power source (50) through the relays (30), and electrically connected to the measuring unit (40).

## Description

### Technical Field

The present invention relates to a probe card, an inspecting device, and an inspecting method for inspecting specifically a microstructure, e.g., an MEMS (Micro Electro Mechanical System), and a computer program for inspecting a microstructure.

### Background Art

Recently, an MEMS which is a device having various functions, such as mechanical, electrical, optical, and chemical functions, integrated by using specifically a semiconductor microfabrication technology or the like receives attention. An example of an MEMS technology which has been utilized so far is to put an MEMS device on micro sensors, such as accelerometers, pressure sensors, and airflow sensors as various sensors for automobiles and medical services. Adapting the MEMS technology to an inkjet printer head enables an increase in the number of nozzles which jet out inks and enables accurate ink jetting, thus improving a print quality and speeding up a print speed. Further, micro mirror arrays used by reflecting projectors are known as general MEMS devices.

It is expected that future development of various sensors and actuators using the MEMS technology will develop applications to optical-communication mobile devices, peripheral devices of computing machines, and further biological analyses and portable power sources. The technology search report vol. 3 (issued on March 28, 2003, by the technology research and information office of the industrial science and technology polity and environmental bureau, and the industrial machinery division of the manufacturing industries bureau, Japan ministry of economy, trade and industry) reports various MEMS technologies under the topic "present situations and issues of technologies regarding MEMS".

A scheme of appropriately inspecting MEMS devices becomes important together with the development of the MEMS devices because of their fine structures. Conventionally, the characteristic of an MEMS device is evaluated by rotating the device after packaging, or by means of vibration or the like, and detection of defects after microfabrication by performing appropriate inspection at an early stage like a wafer state improves the yield and further reduces a manufacturing cost.

### Disclosure of Invention

### Problem to be Solved by the Invention

In general, microstructures having a minute movable portion like an accelerometer are devices which change a responsive characteristic with respect to a minute movement. Accordingly, to evaluate the characteristic thereof, it is necessary to perform highly precise inspection.

Various tests can be performed on the devices, and in a case where the electrical characteristic is subjected to inspection, a probe as a contact is electrically connected to the inspection electrode of a device, an electrical signal is transmitted through the probe, thereby performing inspection on the device.

Meanwhile, when the inspection electrode (sometimes called electrode pad) is formed of a material which is easily oxidized, such as aluminum, copper, or a solder, because an insulating capsule like an oxide film is formed on the surface of the inspection electrode in an inspection stage, even if the probe is caused to electrically contact the inspection electrode, the electrical contact therebetween is unstable. In particular, when the inspection electrode is formed of generally-used aluminum, an extremely hard oxide film (insulating capsule) is formed on the surface of the inspection electrode, and this raises a problem such that it is difficult to establish electrical contact between the probe and inspection electrode.

Consequently, it is necessary to ensure electrical contact between the probe and the inspection electrode by inserting the leading end of the probe into the oxide film on the surface of the inspection electrode while applying a needle pressure.

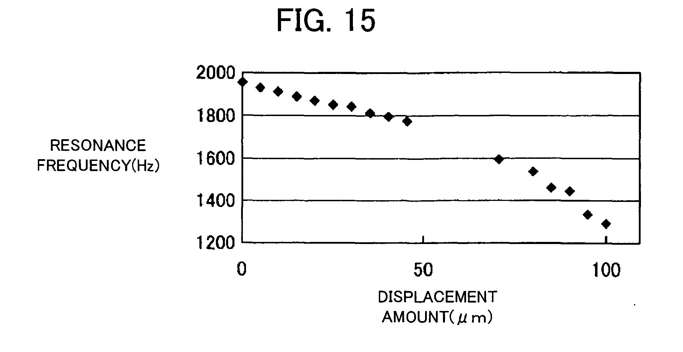

FIG 15 is a diagram for explaining a resonance frequency when the leading end of a probe is inserted into the inspection electrode of an accelerometer.

The horizontal axis represents the displacements of a probe card having a probe whose leading end is pressed against the inspection electrode. The vertical axis represents the values of the resonance frequencies. As the displacement amount of pressing the leading end of the probe against the inspection electrode increases, the value of the needle pressure increases.

With reference to FIG 15, as the needle pressure increases, the resonant frequency decreases. This indicates that the frequency characteristic of a device changes because of the needle pressure.

In particular, in the case of a microstructure having a movable portion like an MEMS device, there is a possibility such that the motion of the movable portion changes, i.e., the responsive characteristic of the device changes as the probe comes in contact therewith. Because of the needle pressure of the probe, excessive stress is applied to the microstructure, so that the motion of the movable portion thereof changes.

Therefore, to perform highly precise observation, i.e., to observe the original responsive characteristic of the device, it is desirable that the needle pressure should be reduced as much as possible and the direction of the needle pressure should be limited in such a way that the microstructure does not deform.

The present invention has been made in view of the foregoing problems, and it is an object of the invention to provide a microstructure probing method, a probe card, an inspecting device, an inspecting method and an inspecting program which suppress the effect of needle pressure in contacting a probe to an inspection electrode to suppress a change in the device characteristic, thereby enabling highly precise inspection.

### Means for Solving the Problem

A microstructure probe card according to the first aspect of the invention is for inspecting a characteristic of at least one microstructure formed on a substrate and having a movable portion, and comprises: two probes for one inspection electrode to cause the inspection electrode provided on the microstructure and a probe provided on the probe card to conduct each other by employing fritting phenomenon.

The probe card further comprises conduction means for causing the inspection electrode and the probe to conduct each other by employing fritting phenomenon.

It is preferable that the probe card should further comprise fluctuating means for causing the movable portion of the microstructure to fluctuate to inspect a characteristic of the microstructure.

In particular, the fluctuating means includes at least one sound-wave generation means for outputting a test sound wave with respect to the movable portion of the microstructure.

Note that the leading end of the probe which is supposed to contact the inspection electrode of the microstructure contacts the inspection electrode of the microstructure perpendicularly.

A microstructure inspecting device according to the second aspect of the invention is for inspecting a characteristic of at least one microstructure formed on a substrate and having a movable portion, and comprises: means for causing a probe to contact an inspection electrode of the microstructure; and conduction means for causing the inspection electrode and the probe to conduct each other by employing fritting phenomenon.

It is preferable that the conduction means should include: a fritting power source used for applying a voltage to the inspection electrode to cause the fritting phenomenon; a measuring unit which is electrically connected to the inspection electrode and outputs an inspection signal for executing a predetermined inspection; and a switching circuit which is connected to the fritting power source when the fritting phenomenon is caused, and connected to the measuring unit when the predetermined inspection is executed.

It is preferable that the conduction means should include: voltage output means for applying a voltage signal which causes fritting phenomenon to the inspection electrode or applying an inspection voltage signal for executing a predetermined inspection to the inspection electrode; and detection means for detecting a signal detected from the inspection electrode in response to the inspection voltage signal.

The microstructure inspecting device further comprises at least one sound wave generation means for outputting a test sound wave with respect to the movable portion of the microstructure.

Note that the microstructure corresponds to either one of an accelerometer and an inclined angle sensor.
In particular, the accelerometer and the inclined angle sensor correspond to a multi-axes accelerometer and a multi-axes inclined angle sensor, respectively.

A microstructure inspecting method according to the third aspect of the invention is for inspecting a characteristic of at least one microstructure formed on a substrate and having a movable portion, and comprises: a contact step of contacting a probe to an inspection electrode of the microstructure; and a conduction step of causing the inspection electrode and the probe to conduct each other by employing fritting phenomenon.

It is preferable that the conduction step should include a step of connecting the probe to a fritting power source to cause the fritting phenomenon, and applying a voltage to the inspection electrode, and the method further comprises a step of outputting an inspection signal for executing a predetermined inspection to the inspection electrode after the inspection electrode and the probe are conducted each other.

In particular, the method further comprises a step of detecting a signal detected from the inspection electrode in response to the inspection signal.

It is preferable that the contact step should cause the probe to contact the inspection electrode of the microstructure perpendicularly.

It is preferable that the contact step should further include a contact detection step of detecting that the inspection electrode and the probe come in contact with each other.

It is preferable that the contact detection step should be performed by detecting a change in an electrical resistance between the probe which contact one inspection electrode.

Further, the contact step includes a displacement step of causing the probes to displace with respect to the inspection electrode by a predetermined displacement amount after the contact detection step.

Note that in the displacement step, the predetermined displacement amount that the probe is displaced with respect to the inspection electrode is the same amount to all microstructures formed on the substrate.

The inspecting method of the invention further comprises a fluctuation step of causing the movable portion of the microstructure to fluctuate to inspect the characteristic of the microstructure.

Note that the fluctuation step is performed after the conduction step.

A microstructure inspecting method according to the fourth aspect of the invention is for inspecting a characteristic of at least one microstructure formed on a substrate and having a movable portion, and comprises: a contact detection step of detecting that an inspection electrode of the microstructure and a probe come in contact with each other.

The method further comprises a displacement step of causing the probe to displace with respect to an inspection electrode by a predetermined displacement amount after the contact detection step.

In particular, in the displacement step, a predetermined movement amount that the probe is moved with respect to the inspection electrode is the same amount to all microstructures formed on the substrate.

A computer program according to the fifth aspect of the invention is for inspecting a characteristic of at least one microstructure formed on a substrate and having a movable portion, and allows a computer to function as: contact means for causing an inspection electrode of the microstructure and a probe to contact each other, and conduction means for causing the inspection electrode and the probe to conduct each other by employing fritting phenomenon.

A computer program according to the sixth aspect of the invention is for inspecting a characteristic of at least one microstructure formed on a substrate and having a movable portion, and allows a computer to function as: microstructure inspecting means which includes contact detection means for detecting that an inspection electrode of the microstructure and a probe come in contact with each other.

### Brief Description of Drawings

[FIG. 1] A schematic structural diagram showing a microstructure inspecting device according to an embodiment of the invention.
[FIG. 2] A diagram for explaining a probe card and a wafer both shown in FIG. 1.
[FIG. 3] A diagram showing a three-axes accelerometer as viewed from the device top face.
[FIG. 4] A schematic view of the three-axes accelerometer.
[FIG. 5] A conceptual diagram for explaining deformations of weights and beams when accelerations in individual axial directions are applied.
[FIG.6] A circuit diagram showing the structure of a Wheatstone bridges provided for each axis.
[FIG 7] A diagram for explaining an output response of the three-axes accelerometer with respect to an inclined angle.
[FIG. 8] A diagram for explaining the relationship between a gravitational acceleration (input) and a sensor output.
[FIG 9] A diagram for explaining a frequency characteristic of the three-axes accelerometer.
[FIG. 10] A diagram for explaining a prober unit according to the embodiment of the invention.
[FIG. 11] A flowchart showing an example of the operation of a probe according to the embodiment of the invention.
[FIG. 12] A diagram for explaining another prober unit according to the embodiment of the invention.
[FIG. 13] A diagram for explaining the other prober unit according to the embodiment of the invention.
[FIG. 14] A structural diagram showing a probe card according a second modified example of the embodiment of the invention.
[FIG 15] A diagram for explaining a resonant frequency when the leading end of a probe is pressed against the inspection electrode of an accelerometer.

### Explanation of Reference Numerals

- 1: Inspecting device
- 5: Inspecting unit
- 10, 10#: Probe card
- 11, 11#: Probe controller
- 12: Loader unit
- 15: Wafer
- 20: Main chuck
- 25, 25#: Prober unit
- 30: Relay circuit
- 40, 40#: Measuring unit
- 41, 41#: Driver
- 42: Comparator
- 50: Fritting power source

### Best Mode for Carrying Out the Invention

An explanation will be given of an embodiment of the invention with reference to the drawings. Note that the same or corresponding portions in the drawings are denoted by the same reference numbers and the explanations thereof will not be repeated.

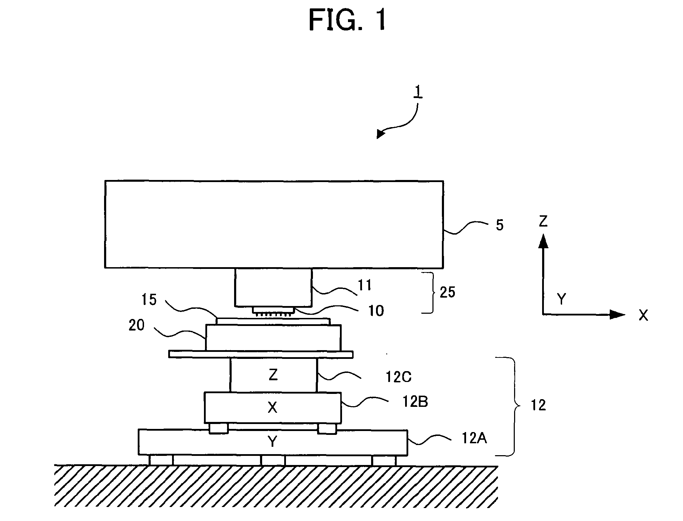

FIG 1 is a schematic structural diagram showing a microstructure inspecting device 1 according to the embodiment of the invention.
With reference to FIG 1, the inspecting device 1 of the embodiment of the invention has a loader unit 12 which feeds an object 15 to be tested (e.g., a wafer), a prober unit 25 which performs electrical characteristic inspection on the wafer 15, an inspecting unit 5 which receives a result from the prober unit 25 and determines the state of the wafer 15, and a non-illustrated controller which controls those units.

The loader unit 12 has a mounting unit (not shown) on which a cassette retaining, for example, twenty five wafers 15, is mounted, and a wafer feeding mechanism which feeds the wafers 15 one by one from the cassette of the mounting unit.

Provided as the wafer feeding mechanism is a main chuck 20 that moves in three-axes directions through X, Y, Z tables 12A, 12B, and 12C which are three-axes (X axis, Y axis, and Z axis) moving mechanism, and rotates the wafer 15 clockwise and counterclockwise in a θ direction. To be more precise, the Y table 12A which moves in the Y direction, the X table 12B which moves in the X direction over the Y table 12A, and the Z axis table 12C which are disposed in such a way that the central axle thereof is brought into line with the center of the X table 12B and moves up and down in the Z direction are provided, and the main chuck 20 is caused to move in the X, Y, and Z directions. It rotates clockwise and counterclockwise through a non-illustrated θ drive mechanism within a predetermined range with the central axis taken as the center.

The prober unit 25 has a probe card 10 which causes a probe and an electrode pad formed of a conductive metal, such as copper, copper alloy, or aluminum, on the wafer 15 to be electrically conducted each other using fritting phenomenon, an alignment mechanism (not shown) which aligns the probe of the probe card 10 with the wafer 15, and a probe controller 11 which controls the probe card 10, and causes the probe of the probe card 10 to electrically contact the electrode pad of the wafer 15 to perform inspection for the electrical characteristic of the wafer 15.

Before explaining the inspection by the inspecting device according to the embodiment of the invention, first, an explanation will be given of a microstructure three-axes accelerometer which is a test object.

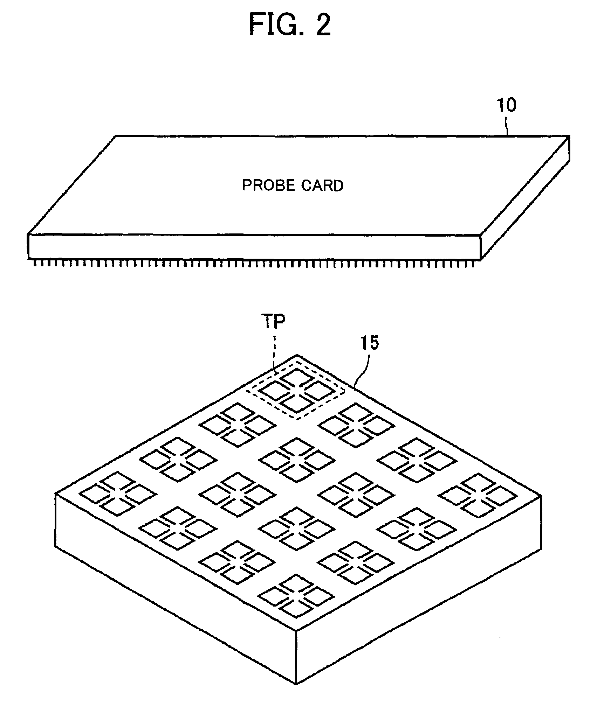

FIG 2 is a diagram for explaining the probe card 10 and the wafer 15 both shown in FIG 1.
As shown in FIG 2, the probe card 10 is provided with a plurality of probes, and is undergone alignment adjustment to a predetermined position on the wafer by the alignment mechanism. Note that in the embodiment, the wafer 15 is provided with a plurality of microstructure chips TP each of which is a three-axes accelerometer.

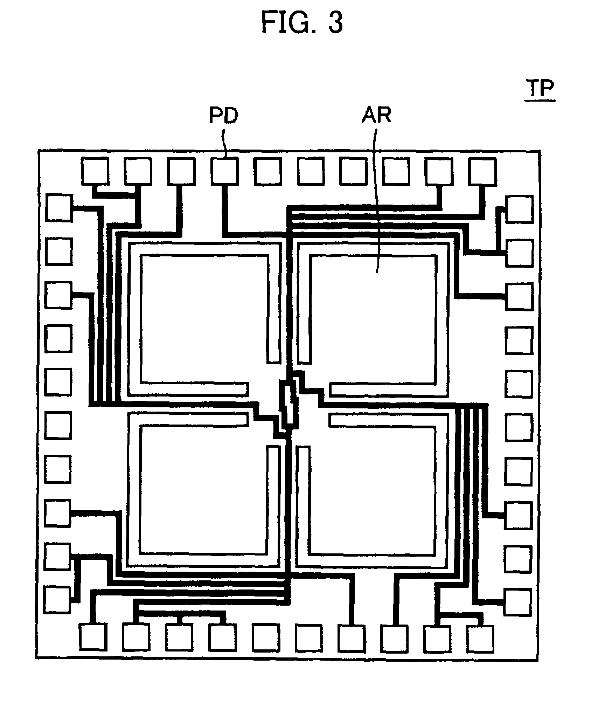

FIG 3 is a diagram showing the three-axes accelerometer as viewed from the device top face.
As shown in FIG 3, a chip TP formed on a wafer substrate has a plurality of electrode pads PD disposed therearound. Metal wirings for electrical signal transmission to the electrode pads or therefrom are provided. Four weights AR formed in a clover-like shape are disposed at the center.

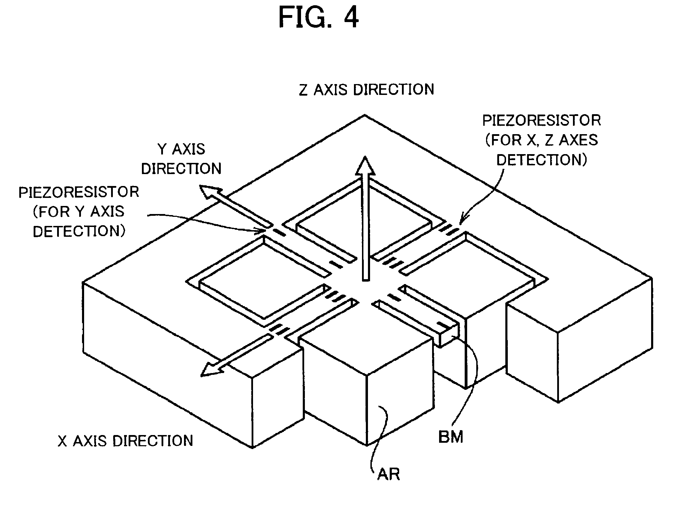

FIG 4 is a schematic diagram showing the three-axes accelerometer.
With reference to FIG 4, the three-axes accelerometer is piezoresistor type, and has piezoresistors which are detection devices as diffusion resistances. The piezoresistor type accelerometer can utilize an inexpensive IC process, and the sensitivity thereof does not decrease even if the piezoresistor is so formed as to have a small size, and is advantageous for miniaturization and cost reduction.

As a specific structure, the weights AR at the center are structured in such a manner as to be supported by four beams BM. The beams BM are formed so as to bisect one another at right angles in the two axes directions of X and Y, and have the four piezo resistors per axis. The four piezoresistors for Z axis direction detection are disposed beside the piezoresistor for X axis direction detection. The top faces of the weights AR are formed in a clover-like shape, and connected to the beams BM at the center. Employing a clover-like structure makes it possible to realize a small-size highly sensitive accelerometer because the weights AR can be large and the beam length can be elongated.

Employed as the operation principle of the piezoresistor type three-axes accelerometer is a mechanism such that the beams BM deform when the weights receive an acceleration (inertial force), and the acceleration is detected through changes in the resistance values of the piezoresistors formed on the surfaces of the beams BM. Sensor outputs are to be taken out from the outputs of Wheatstone bridges to be discussed later and incorporated in the individual three axes separately.

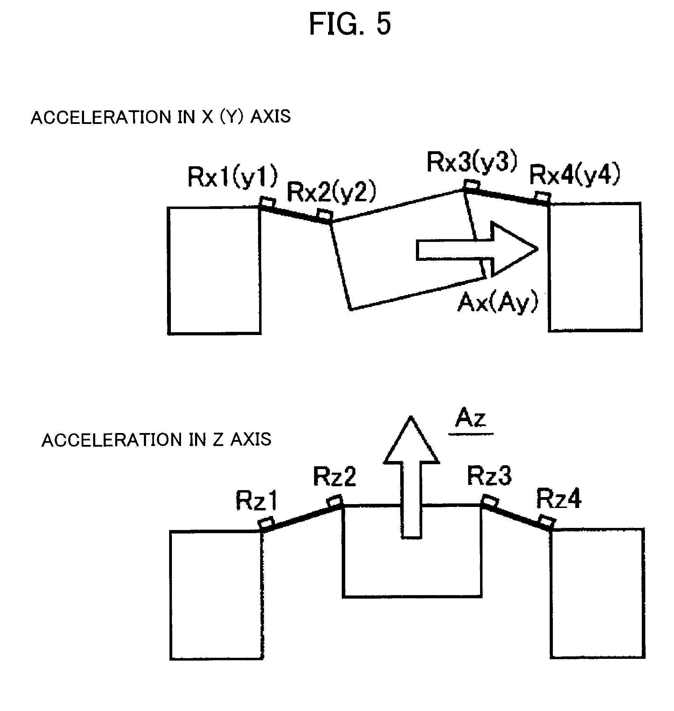

FIG 5 is a conceptual diagram for explaining deformations of the weights and beams when accelerations in the individual axial directions are received.
As shown in FIG 5, the piezoresistors have a character (piezoresistor effect) such that the value of resistance thereof changes due to applied distortion, and the value of resistance increases in the case of pulling distortion and reduces in the case of compression distortion. In the embodiment, X-axis-direction detection piezoresistors Rx1 to Rx4, Y-axis-direction detection piezoresistors Ry1 to Ry4, and Z-axis-direction detection piezoresistors Rz1 to Rz4 are exemplified.

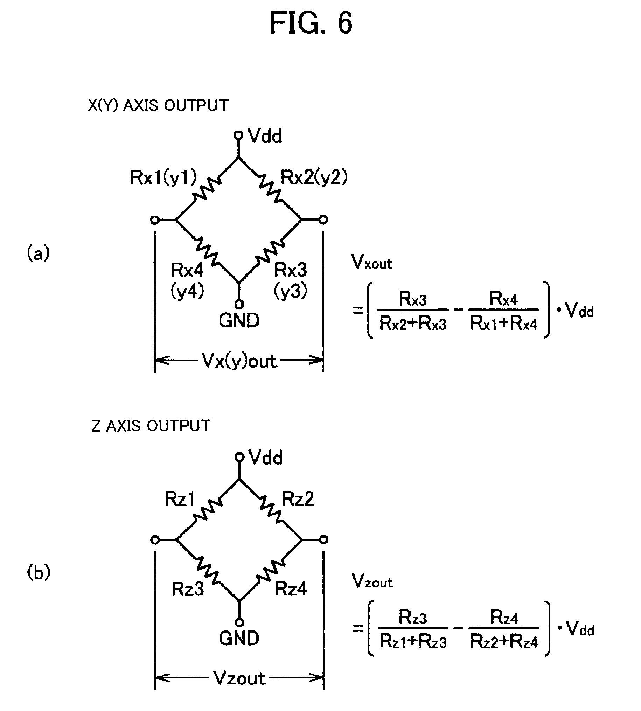

FIG 6 is a circuit diagram showing the structure of a Wheatstone bridge provided for each axis.
FIG 6(a) is a circuit diagram showing the structure of a Wheatstone bridge in the X (Y) axis. Output voltages of the X axis and the Y axis are denoted by Vxout and Vyout, respectively.
FIG 6(b) is a circuit diagram showing the structure of a Wheatstone bridge in the Z axis. An output voltage in the Z axis is denoted by Vzout.

As mentioned above, the values of resistances of the four piezoresistors in each axis change due to applied distortion, and based on these changes, in the X and Y axes, for example, each piezoresistor detects an acceleration component from the output of a circuit formed by the Wheatstone bridge in each axis as an output voltage independently separated from one another. Note that to constitute the foregoing circuit, the metal wirings and the like shown in FIG 3 are connected together, and output voltages for the individual axes are detected from assigned electrode pads.

The three-axes accelerometer can detect the DC component of an acceleration and can be used as an inclined angle sensor which detects a gravitational acceleration.

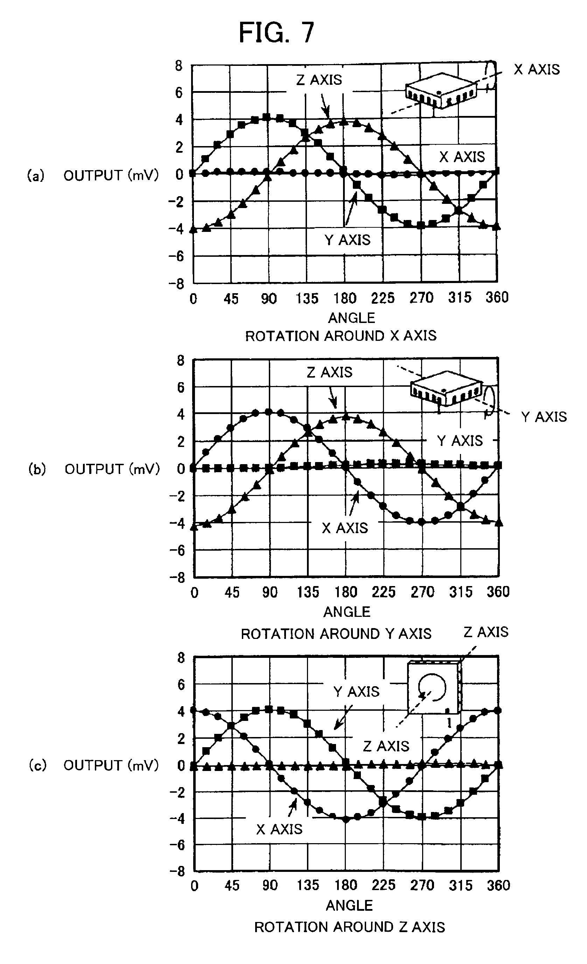

FIG 7 is a diagram for explaining an output response of the three-axes accelerometer with respect to an inclined angle.
The sensor shown in FIG 7 was rotated around the X and Z axes, and the bridge outputs for the X, Y, and Z axes, respectively, were measured through a voltmeter. A low-voltage power source of +5 V was used as the power source for the sensor. A value having a zero-point offset of each axis output arithmetically reduced is plotted at each measuring point in FIG 7.

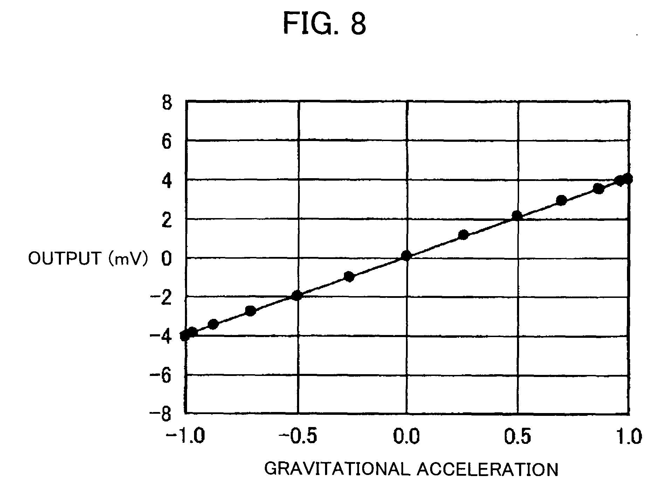

FIG 8 is a diagram for explaining the relationship between a gravitational acceleration and a sensor output.
The input/output relationship shown in FIG 8 is one that gravitational acceleration components relating to the X, Y, and Z axes, respectively, are calculated from the cosine of an inclined angle in FIG 7, a relationship between a gravitational acceleration (input) and a sensor output is acquired and the input/output linearity thereof is evaluated. That is, the relationship between an acceleration and an output voltage is almost linear.

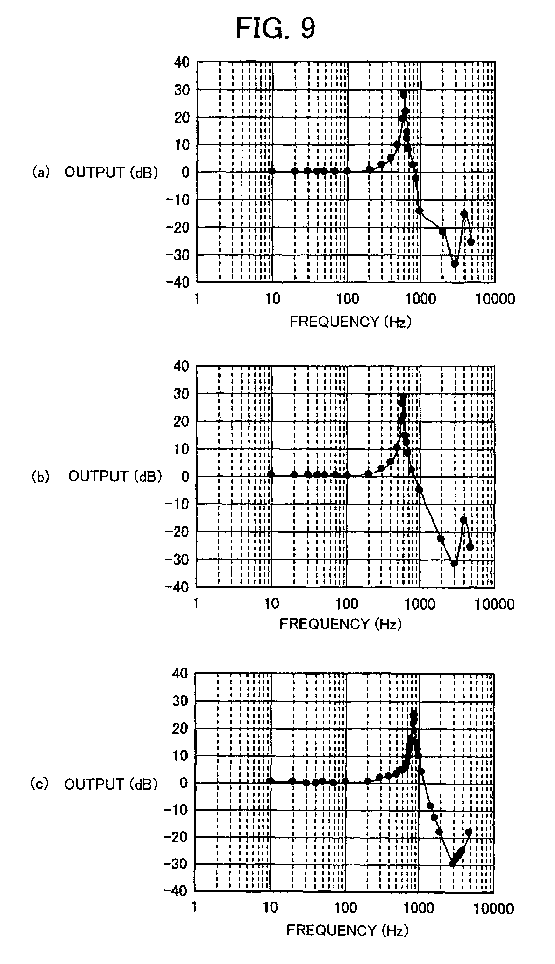

FIG 9 is a diagram for explaining a frequency characteristic of the three-axes accelerometer.
As shown in FIG 9, as an example, the frequency characteristics of sensor outputs for the X, Y, and Z axes, respectively, have flat frequency characteristics in all three axes up to approximately 200 Hz, and resonances occur at 602 Hz in the X axis, at 600 Hz in the Y axis, and at 833 Hz in the Z axis. Note that the frequency characteristic here represents the frequency characteristic after packaging.

Hereinafter, an explanation will be given of a probing method according to the embodiment of the invention.

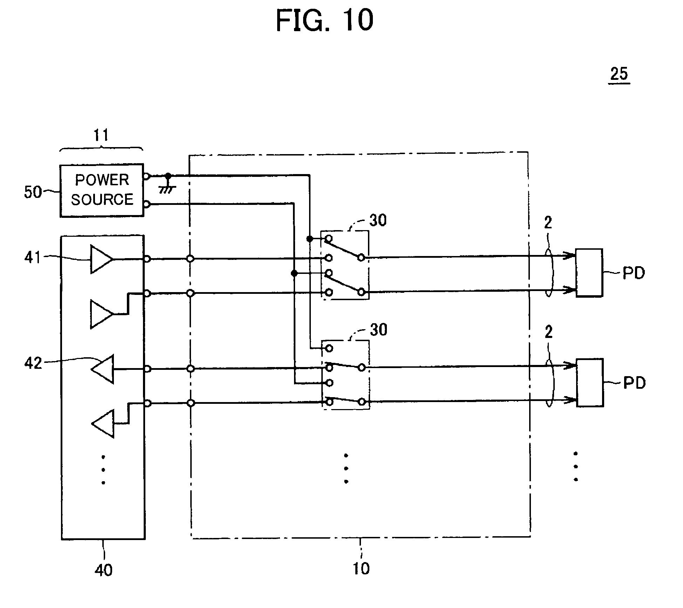

FIG 10 is a diagram for explaining the prober unit 25 according to the embodiment of the invention.
With reference to FIG 10, the prober unit 25 of the embodiment of the invention includes the probe card 10 and the probe controller 11, and the probe controller 11 includes a fritting power source 50 and a measuring unit 40.

The probe card 10 has a pair of probes 2 each of which contact one of the plurality of electrode pads PD of the wafer, and relays 30 connected to the respective probes 2, and the pair of probes 2 are switched over between the measuring unit 40 and the fritting power source 50 and connected through the relays 30.

The measuring unit 40 has drivers 41 and comparators 42, and is structured in such a manner as to output an inspection signal from a driver 41, and compare and determine a result thereof by a comparator 42. Although a structure such that the two drivers and the two comparators are connected to the pair of probes 2 is illustrated, a structure such that one driver and one comparator are connected can be employed.

To reduce an effect on a microstructure due to stress when the probe 2 is pressed against the electrode pad PD, if a needle pressure is reduced, a contact resistance between the probe 2 and the electrode pad PD increases. The stress of a needle pressure and a contact resistance are in a trade-off relationship. Therefore, in an inspecting scheme according to the embodiment of the invention, the effect of a needle pressure is suppressed by employing fritting phenomenon. Note that the fritting phenomenon is phenomenon such that when a potential gradient applied to an oxide film formed on the surface of a metal (electrode pad in the invention) becomes 10⁵ to 10⁶ V/cm or so, a current is caused to flow because of the thickness of the oxide film and unevenness of the composition of the metal, and the oxide film is destroyed.

It is desirable that the compliance characteristic (flexibility) of the probe 2 should be high. To be more precise, the height of the leading end of the probe 2 with respect to the wafer 15 may not be constant, and may slightly differ for each probe 2. The evenness accuracy of the height of the leading end of the probe 2 and the manufacturing cost of the probe card 6 are in a trade-off relationship. If the compliance characteristic of the probe 2 is high when the differences of the leading ends of the probes 2 are absorbed and all probes 2 are contacted to the electrode pads, a needle pressure difference for each probe 2 is small. To make the compliance characteristic high, even if there is a difference in the heights of the leading ends of the probes 2, the needle pressures thereof can be almost uniform.

It is also structured in such a manner as to detect that the leading end of the probe 2 comes in contact with the electrode pad PD, and the probe 2 is pressed against the electrode pad PD by a certain length from that contact point (overdrive amount). In particular, in a process of forming a conformational structure like an MEMS on a wafer 15, it is difficult to keep the surface of the wafer 15 completely flat, and the height for each chip differs. By detecting that the leading end of the probe 2 comes in contact with the electrode pad PD, and pressing the probe 2 by a certain overdrive amount, a needle pressure in measuring can be uniform for each chip TP even if the height of each chip TP differs.

To detect that the leading end of the probe 2 comes in contact with the electrode pad PD, there are a method of measuring a distance between the probe card an the electrode pad by, for example, laser measurement, a method of detecting a contact state by extracting a shape from images of the leading end of the probe 2 and the electrode pad PD, a detection method by a change in a electrical resistance between the pair of probes 2 to be used for fritting, and the like. In the case of the method by a change in the electrical resistance between the pair of probes 2, detection can be made when one of the pair of probes 2 contacts one electrode pad PD and the electrical resistance becomes small from an open state where the electrical resistance is extremely large.

The differences in the heights of the individual chips TP on the wafer 15 and the differences in the heights of the leading ends of the probes 2 are absorbed in this manner, thus enabling inspection on a microstructure under a condition such that a needle pressure is uniform.

At least the leading end of the probe 2 is formed in such a manner as to perpendicularly contact the inspection electrode of a microstructure. Accordingly, a needle pressure is applied only perpendicularly (in the Z axis direction in FIG 4), application of the needle pressure in the horizontal direction (in the X axis direction or the Y axis direction in FIG 4) is suppressed, thus suppressing a disturbance originating from the needle pressure.

When the wafer 15 is to be inspected, first, the pair of probes 2 are contacted to the respective electrode pads PD, and then the pair of probes 2 are connected to the fritting power source 50 through the relays 30. It is preferable that the probe 2 should be contacted to a device, i.e., each electrode pad PD, in a perpendicular direction. When the probe is contacted to the electrode pad in an oblique direction, the effect of a needle pressure may appear in the X axis and the Y axis.

The method of detecting that the probe 2 comes in contact with the electrode pad PD, and pressing the probe 2 against the electrode pad PD by a certain overdrive amount after contact has advantages such that the probe condition is held constant and an effect on a chip TP is reduced in the probe 2 and a probing method which do not employ fritting. Further, a method of forming the shape of the leading end of the probe 2 in such a manner as to perpendicularly contact the electrode pad PD, and causing the leading end of the probe 2 to contact the electrode pad PD in a perpendicular direction have an advantage such that an effect on a chip TP is reduced in the probe 2 and a probing method which do not employ fritting.

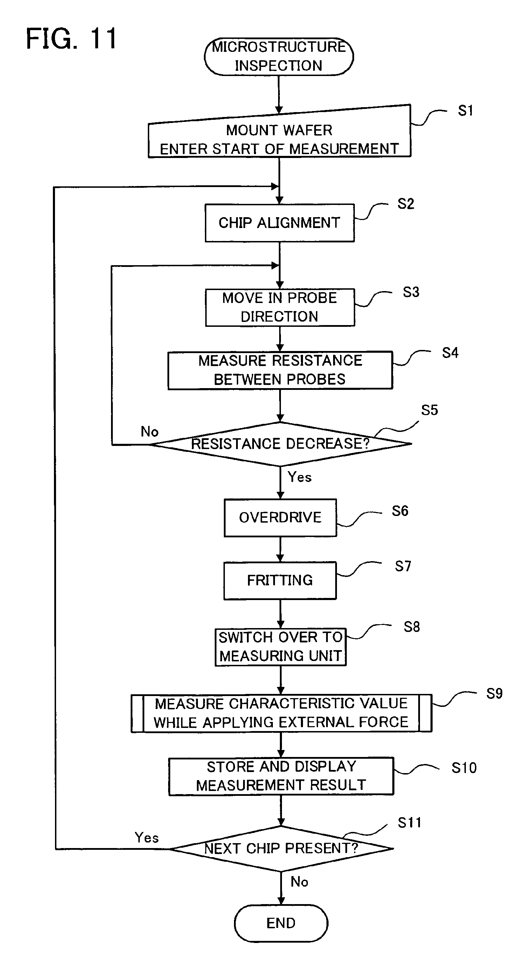

FIG 11 is a flowchart showing an example of an operation of the probe according to the embodiment of the invention. Prior to the inspection on a microstructure, an overdrive amount is set to an appropriate value beforehand so that the contact resistance between the probe 2 and the electrode pad PD is reduced and stress originating from a needle pressure of the probe 2 can be vanished.

When the wafer 15 is mounted on the main chuck 20 and the start of the inspection is entered (step S 1), a chip to be inspected is selected and the position of the main chuck 20 in the X-Y direction and the azimuth angle θ are changed to do alignment control so that the selected chip positions at the location of the probe 2 (step S2).

Next, the wafer 15 is moved to come close to the probe card 10, and it is detected that the leading end of the probe 2 comes in contact with the electrode pad PD. That is, the wafer 15 is moved in the direction of the probe card 10 (step S3), the resistance between the pair of probes which cause fritting phenomenon is measured (step S4), and until the resistance decreases (step S5), the wafer 15 is kept moving closer to the probe card. The probe 2 is moved in the electrode pad PD direction D by a certain overdrive amount from that point (step S6) to keep a needle pressure at a certain small value. By causing the probe 2 to contact each chip TP of the wafer 15 and then to displace by a predetermined overdrive amount, an effect on the chip TP is minimized, and inspection can be carried out for each chip TP under the same condition.

Subsequently, a voltage is applied to one probe 2 in the pair of probes 2 from the fritting power source 50. When a voltage is gradually increased, a current which breaks out an oxide film between the pair of probes 2 flows between the pair of probes 2 by fritting phenomenon based on a difference in a voltage applied between the pair of probes 2, and the probe 2 is electrically conducted with the electrode pad PD (step S7). Next, the pair of probes 2 are switched over from the fritting power source 50 side to the measuring unit 40 side through the relays 30 and electrically connected to the measuring unit 40 (step S8). Although the explanation has been given of a structure such that switching between the fritting power source 50 and the measuring unit 40 is realized by the relays 30, the structure is not limited to this case, and it is possible to perform switching by semiconductor switches instead of the relays 30.

Thereafter, an inspection signal is applied from the measuring unit 40 to the electrode pad PD through the probe 2, and the characteristic of the chip TP is measured while applying external force to the chip TP (step S9). A measuring result is stored, and displayed if needed (step S10). When there is another chip TP to be inspected on the wafer 15 (step S 11: Yes), this chip TP is selected, and operations from alignment control (step S2) to storing and displaying of a measuring result (step S10) are repeated. When there is no remaining chip TP to be inspected on the wafer 15 (step S11: No), the inspection is finished.

By employing fritting phenomenon, a needle pressure between the probe 2 and the electrode pad PD can be set to an extremely small value, so that highly reliable inspection becomes possible without a possibility that the electrode pad or the like is damaged.

A program which allows a computer to execute the probing method of the embodiment of the invention can be stored in a memory medium, such as an FD, a CD-ROM or a hard disk, beforehand. In this case, the non-illustrated controller is provided with a driver device which reads out the program stored in a recording medium, receives the program through the driver device, the prober unit 25 is controlled under the control of the controller, and then the foregoing probing method is executed. In a case where a network connection is established, the program is downloaded from a server, the prober unit 25 is controlled under the control of the controller, and then the foregoing probing method is executed.

### (First Modified Example of Embodiment)

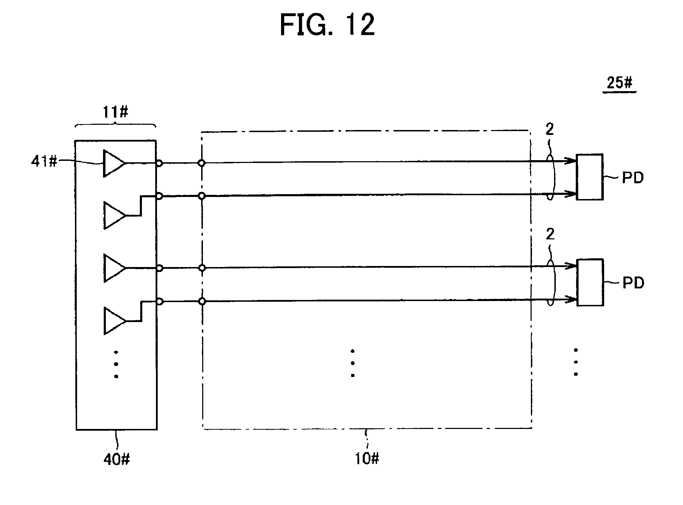

FIG 12 is a diagram for explaining another prober unit 25# according to the embodiment of the invention.
With reference to FIG 12, the prober unit 25# has a probe card 10# and a probe controller 11#. The probe card 10# is structured in such a manner as to have no relay 30 in comparison with the probe card 10. The probe controller 11# has a measuring unit 40#, and is structured in such a manner as to have no fritting power source 50 in comparison with the probe controller 11.

In the foregoing structure, drivers 41 # included in the measuring unit 40# have the same function as that of the foregoing fritting power source 50. Specifically, they are structured in such a manner as to be able to directly apply a certain degree of voltage, which can cause fritting phenomenon, to the probe 2. After fritting phenomenon is caused, they apply an inspection signal like the drivers 41. It is not illustrated but comparators 42 are built in, so that a signal which is output in response to the inspection signal can be subjected to comparison and determination.

Accordingly, fritting phenomenon can be caused by a simple structure having no relay 30 and fritting power source 40 to perform device inspection.

### (Second Modified Example of Embodiment)

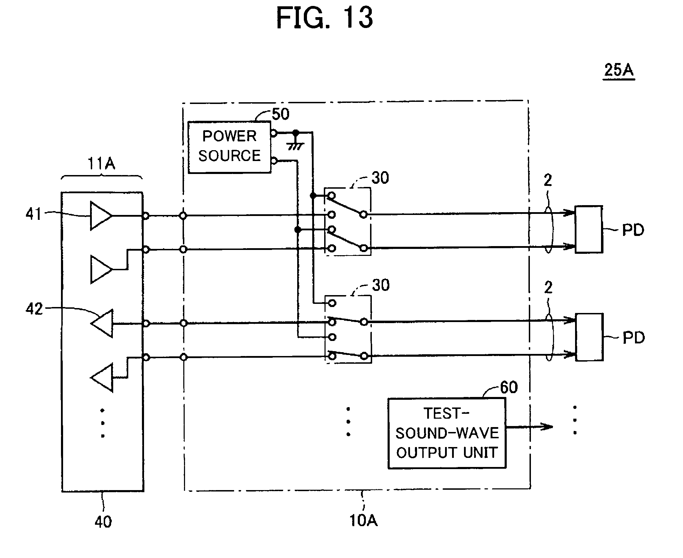

FIG 13 is a diagram for explaining an other prober unit 25A according to the embodiment of the invention.
With reference to FIG. 13, the prober unit 25A has a probe card 10A and a probe controller 11A. The probe card 10A has the built-in fritting power source 50 in comparison with the probe card 10. In accordance with this structure, the probe controller 11A has only the measuring unit 40.

Employing such a structure allows the probe card itself to have a function of causing fritting phenomenon, and enables the probe and an inspection electrode to conduct each other.

In the example, the probe card 10A further includes a test-sound-wave output unit 60.

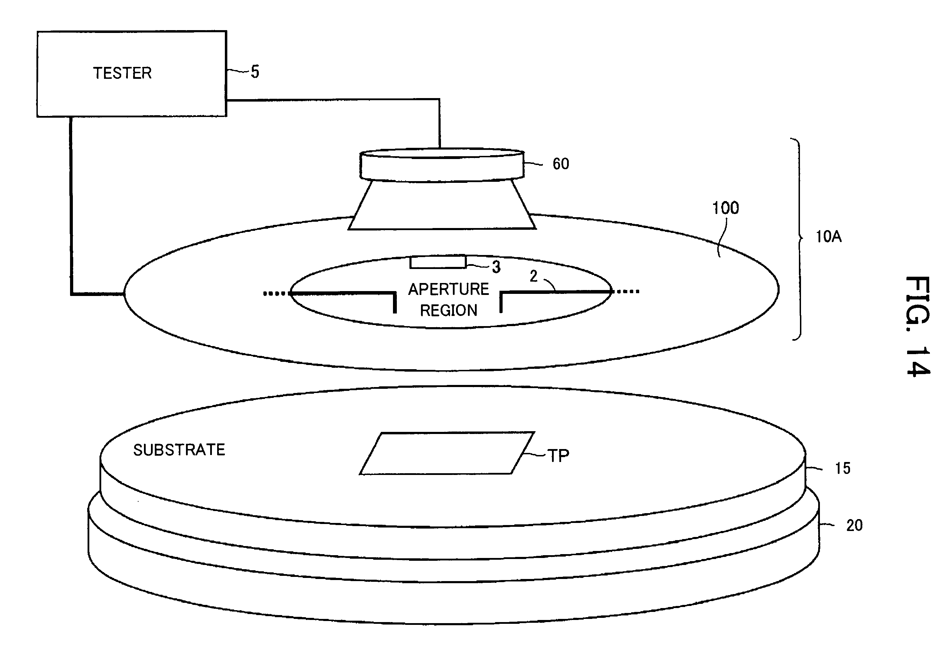

FIG 14 is a structural diagram of the probe card 10A according to the second modified example of the embodiment The probe card 10A has the test-sound-wave output unit 60. A possible test-sound-wave output unit 60 is, for example, a speaker. To cause a sound wave from the test-sound-wave output unit 60 to hit a chip TP subjected to inspection, the probe card 10A has an aperture region formed at the position of the test-sound-wave output unit. A substrate 100 of the probe card 10A has the probes 2 attached so as to protrude into the aperture region. A microphone 3 is provided near the aperture region. A sound wave in the vicinity of a chip TP is caught by the microphone 3, and a test sound wave which is output from the test-sound-wave output unit 60 is controlled in such a way that a sound wave applied to a chip TP has a desired frequency component.

It is supposed that the test-sound-wave output unit 60 generates a test sound wave in response to a test instruction given to the probe card 10A. As a result, the movable portion of the three-axes accelerometer becomes to make a motion, and it is possible to detect a signal according to the motion of the movable portion from an inspection electrode through the probe which is conducted by fritting phenomenon. This signal is measured and analyzed through the measuring unit 40 to perform device inspection.

The explanation has been given of the case where the probe card 10A has the built-in test-sound-wave output unit which generates a test sound wave, but the invention is not limited to this case, and for example, a desired inspection (test) can be executed through fluctuating means like a vibration device which fluctuates the movable portion of the three-axes accelerometer, if desired.

In the foregoing embodiment, the three-axes accelerometer is exemplified, but the probe card and the probing method can be applied to not only the three-axes accelerometer, but also other MEMSs, e.g., a microphone.

It should be understood that the foregoing disclosed embodiment is just an example and is not limitative. The scope of the invention should be defined by the following claims, not by the foregoing explanation, and all modifications and equivalents should be included in the scope of the invention.

This application is based on Japanese Patent Application No. 2005-102751, Japanese Patent Application No. 2005-102760, both filed on March 31, 2005, and Japanese Patent Application No. 2005-266720 filed on September 14, 2005. The specifications, claims, and entire drawings of Japanese Patent Application No. 2005-102751, Japanese Patent Application No. 2005-102760, and Japanese Patent Application No. 2005-266720 are incorporated in this specification as references.

### Industrial Applicability

According to the microstructure probing method, the probe card, the inspecting device, the inspecting method and the inspecting program of the invention, a probe is caused to contact the inspection electrode of a microstructure, and the inspection electrode and the probe are conducted each other by employing fritting phenomenon. Therefore, it is possible to suppress an effect of a needle pressure in contacting the probe to the inspection electrode without damaging the probe or the inspection electrode. As a result, it becomes possible to execute a highly precise inspection while suppressing a change in an electrical characteristic due to the effect of the needle pressure.

## Claims

1. A microstructure probe card for inspecting a characteristic of at least one microstructure formed on a substrate and having a movable portion, comprising:
two probes for one inspection electrode to cause said inspection electrode provided on said microstructure and a probe provided on said probe.card to conduct each other by employing fritting phenomenon.

2. The microstructure probe card according to claim 1, further comprising conduction means for causing said inspection electrode and said probe to conduct each other by employing fritting phenomenon.

3. The microstructure probe card according to claim 1, further comprising fluctuating means for causing said movable portion of said microstructure to fluctuate to inspect a characteristic of said microstructure.

4. The microstructure probe card according to claim 3, wherein said fluctuating means includes at least one sound-wave generation means for outputting a test sound wave with respect to said movable portion of said microstructure.

5. The microstructure probe card according to claim 1, wherein a leading end of said probe which are supposed to contact said inspection electrode of said microstructure contacts said inspection electrode of said microstructure perpendicularly.

6. A microstructure inspecting device for inspecting a characteristic of at least one microstructure formed on a substrate and having a movable portion, comprising:
means for causing a probe to contact an inspection electrode of said microstructure; and
conduction means for causing said inspection electrode and said probe to conduct each other by employing fritting phenomenon.

7. The microstructure inspecting device according to claim 6, wherein said conduction means includes:
a fritting power source used for applying a voltage to said inspection electrode to cause said fritting phenomenon;
a measuring unit which is electrically connected to said inspection electrode and outputs an inspection signal for executing a predetermined inspection; and
a switching circuit which is connected to said fritting power source when said fritting phenomenon is caused, and connected to said measuring unit when said predetermined inspection is executed.

8. The microstructure inspecting device according to claim 6, wherein said conduction means includes:
voltage output means for applying a voltage signal which causes fritting phenomenon to said inspection electrode or applying an inspection voltage signal for executing a predetermined inspection to said inspection electrode; and
detection means for detecting a signal detected from said inspection electrode in response to said inspection voltage signal.

9. The microstructure inspecting device according to claim 6, further comprising at least one sound wave generation means for outputting a test sound wave with respect to said movable portion of said microstructure.

10. The microstructure inspecting device according to claim 6, wherein said microstructure corresponds to either one of an accelerometer and an inclined angle sensor.

11. The microstructure inspecting device according to claim 10, wherein said accelerometer and said inclined angle sensor correspond to a multi-axes accelerometer and a multi-axes inclined angle sensor, respectively.

12. A microstructure inspecting method for inspecting a characteristic of at least one microstructure formed on a substrate and having a movable portion, comprising:
a contact step of contacting a probe to an inspection electrode of said microstructure; and
a conduction step of causing said inspection electrode and said probe to conduct each other by employing fritting phenomenon.

13. The microstructure inspecting method according to claim 12, wherein
said conduction step includes a step of connecting said probe to a fritting power source to cause said fritting phenomenon, and applying a voltage to said inspection electrode, and
the method further comprises a step of outputting an inspection signal for executing a predetermined inspection to said inspection electrode after said inspection electrode and said probe are conducted each other.

14. The microstructure inspecting method according to claim 13, further comprising a step of detecting a signal detected from said inspection electrode in response to said inspection signal.

15. The microstructure inspecting method according to claim 12, wherein said contact step causes said probe to contact said inspection electrode of said microstructure perpendicularly.

16. The microstructure inspecting method according to claim 12, wherein said contact step further includes a contact detection step of detecting that said inspection electrode and said probe come in contact with each other.

17. The microstructure inspecting method according to claim 16, wherein said contact detection step is performed by detecting a change in an electrical resistance between said probes which contact one inspection electrode.

18. The microstructure inspecting method according to claim 16, wherein said contact step includes a displacement step of causing said probe to displace with respect to said inspection electrode by a predetermined displacement amount after said contact detection step.

19. The inspecting method according to claim 18, wherein in said displacement step, said predetermined displacement amount that said probe is displaced with respect to said inspection electrode is a same amount to all microstructures formed on said substrate.

20. The microstructure inspecting method according to claim 12, comprising a fluctuation step of causing said movable portion of said microstructure to fluctuate to inspect said characteristic of said microstructure.

21. The microstructure inspecting method according to claim 20, wherein said fluctuation step is performed after said conduction step.

22. A microstructure inspecting method for inspecting a characteristic of at least one microstructure formed on a substrate and having a movable portion, comprising:
a contact detection step of detecting that an inspection electrode of said microstructure and a probe come in contact with each other.

23. The microstructure inspecting method according to claim 22, comprising a displacement step of causing said probe to displace with respect to an inspection electrode by a predetermined displacement amount after said contact detection step.

24. The inspecting method according to claim 23, wherein in said displacement step, a predetermined movement amount that said probe is moved with respect to said inspection electrode is a same amount to all microstructures formed on said substrate.

25. A computer program for inspecting a characteristic of at least one microstructure formed on a substrate and having a movable portion, allowing a computer to function as:
contact means for causing an inspection electrode of said microstructure and a probe to contact each other; and
conduction means for causing said inspection electrode and said probe to conduct each other by employing fritting phenomenon.

26. A computer program for inspecting a characteristic of at least one microstructure formed on a substrate and having a movable portion, allowing a computer to function as:
microstructure inspecting means which includes contact detection means for detecting that an inspection electrode of said microstructure and a probe come in contact with each other.
